Europäisches Patentamt

European Patent Office

Office européen des brevets

(11) Numéro de publication: **0 376 781**
**A1**

## (12) DEMANDE DE BREVET EUROPEEN

(21) Numéro de dépôt: **89403436.2**

(51) Int. Cl.5: **G01R 31/02**

(22) Date de dépôt: **12.12.89**

(30) Priorité: **20.12.88 FR 8816808**

(43) Date de publication de la demande:
**04.07.90 Bulletin 90/27**

(84) Etats contractants désignés:
**DE FR GB NL**

(71) Demandeur: **COMPAGNIE EUROPEENNE DE COMPOSANTS ELECTRONIQUES LCC**
**50, rue Jean -Pierre Timbaud B.P. 301**
**F-92402 Courbevoie(FR)**

(72) Inventeur: **Mentzer, Régis**
**THOMSON-CSF SCPI Cédex 67**
**F-92045 Paris la Défense(FR)**
Inventeur: **Cavuoto, Roger**
**THOMSON-CSF SCPI Cédex 67**
**F-92045 Paris la Défense(FR)**
Inventeur: **Espitalier, Chistian**
**THOMSON-CSF SCPI Cédex 67**
**F-92045 Paris la Défense(FR)**
Inventeur: **Lanier, Daniel**
**THOMSON-CSF SCPI Cédex 67**
**F-92045 Paris la Défense(FR)**
Inventeur: **Matiron, Pierre**
**THOMSON-CSF SCPI Cédex 67**
**F-92045 Paris la Défense(FR)**

(74) Mandataire: **Guérin, Michel et al**
**THOMSON-CSF SCPI**
**F-92045 PARIS LA DEFENSE CEDEX 67(FR)**

(54) **Installation de contrôle automatique de composants électroniques du type chips.**

(57) Installation automatique de contrôle, marquage, et mise en bande de composants chips, en particulier de condensateurs.

Elle comporte une cascade de roues distributrices à alvéoles (2, 18, 42, 43, 44, 34, 22, 26). Certaines de ces roues sont associées à des postes de mesure en continu (30, 38, 51). D'autres (44, 34) sont associées à un dispositif de marquage. Un dispositif de sélection (54) permet de ne mettre sur bande (55) que les pièces bonnes.

Fig.1

# INSTALLATION DE CONTROLE AUTOMATIQUE DE COMPOSANTS ELECTRONIQUES DU TYPE CHIPS

La présente invention se rapporte à une installation de contrôle automatique, ainsi qu'éventuellement de marquage et de mise sur bande, de composants électroniques dits de type "chips", c'est-à-dire de composants électroniques de forme parallélépipédique destinés à être montés en surface sur un circuit imprimé, et comportant de ce fait des terminaisons soudables intégrées au parallélépipède. En particulier, l'invention concerne une installation de contrôle, marquage et mise sur bande, de condensateurs chips.

Actuellement, les opérations qui sont nécessaires entre la sortie de la chaine de fabrication des condensateurs chips et leur conditionnement final en vue de leur livraison aux utilisateurs sont effectées sur des équipements totalement séparés, dont :

- Un premier poste de classement des condensateurs en deux catégories ou plus : à ce poste, tous les condensateurs sans exception sont testés et, pour ceci, il est procédé à une mesure de leur capacité et à une mesure de leur angle de perte (mesure de "tangente"). Les condensateurs sont alors classés, si leur angle de perte est satisfaisant, en par exemple deux catégories

. 1ère catégorie : condensateurs dont la capacité est égale à la capacité nominale à 5 % près ;

. 2ème catégorie : condensateurs dont la capacité est égale à la capacité nominale à 10 % près ;

- Un deuxième poste où sont acheminés tous ces condensateurs, et auquel certains d'entre eux sont soumis à une mesure de résistance d'isolement ainsi qu'à une mesure de tenue au claquage.

- Un troisième poste, où les condensateurs issus de ce deuxième poste sont transférés, qui est le poste de mise sur bande de livraison.

Ces installations de contrôle connues présentent quelques inconvénients. Les manutentions entre les postes successifs sont sources d'erreurs. Les mesures électriques fondamentales que sont la mesure de capacité et la mesure d'angle de perte ne sont quelquefois faites qu'une seule fois, de sorte que ce genre de dispositif n'est pas redondant, ce qui est ennuyeux. La cadence de fonctionnement est limitée, en raison surtout des manutentions consécutives aux transports d'un poste à l'autre. Enfin, il existe un risque, avec de telles installations de contrôle, que des pièces mauvaises ne soient pas détectées et éliminées, de sorte que les bandes de condensateurs peuvent contenir quelques pièces mauvaises parmi les bonnes, ce qui est très gênant.

L'invention vise à remédier à ces inconvénients. Elle se rapporte à cet effet à une installation de contrôle automatique de composants électroniques du type chips, en particulier de condensateurs chips, qui comporte une cascade de roues rotatives distributrices de composants chips, ces roues successives étant agencées pour que deux roues adjacentes soient tangentes l'une à l'autre afin de permettre le transfert un à un des composants chips d'une roue à la suivante au point de tangence de ces deux roues, au moins certaines de ces roues étant associées à des sondes de mesure qui sont aptes à effectuer une prise de mesure de contrôle sur chacun des composants chips transportés par la roue correspondante sans arrêter le mouvement de rotation de cette roue, au moins la première de ces roues étant une roue de collection et de distribution un à un de composants chips d'entrée, et au moins la dernière de ces roues étant une roue de mise sur bande, un à un, des composants chips ayant subi des mesures sur des roues intermédiaires et ayant par suite été sélectionnés comme bons par un organe central de commande et de calcul, des moyens commandés par cet organe central étant en outre prévus pour interdire l'accès à cette dernière roue des composants non sélectionnés, de sorte que seuls des composants sélectionnés sont mis sur bande.

Avantageusement, ladite première roue est une roue distributrice à alvéoles régulièrement réparties sur son pourtour extérieur qui se distingue des roues distributrices de ce type classiquement utilisées par le fait que chaque alvéole de cette roue contient au moins un composant chips.

Avantageusement encore, une roue à alvéoles doubles, chacune de ces alvéoles étant apte à recevoir deux composants chips mis bout-à-bout dans le sens axial, est prévue en sortie de la dernière mesure de contrôle dans le but de classer, en les poussant ou non dans le fond de leur alvéole au moyen d'un dispositif commandé par l'organe central précité, les divers composants en composants sélectionnés comme bons ou non.

Avantageusement encore, au moins une des roues intermédiaires est associée avec un dispositif de marquage des composants chips.

Avantageusement enfin, au moins une des roues intermédiaires est associée à un dispositif de mesure dont au moins une partie est "embarquée", c'est-à-dire est synchronisée en rotation avec cette roue.

De toute façon, l'invention sera bien comprise, et ses avantages et autres caractéristiques ressortiront, au cours de la description suivante d'un exemple non limitatif de réalisation d'une installation de contrôle automatique de condensateurs chips, en référence au dessin schématique annexé dans lequel :

- Figure 1 est une vue en plan très simplifiée de l'ensemble de cette installation ;

- Figure 2 est une vue partielle en perspective écorchée de la roue distributrice d'entrée qui équipe cette installation ;

- Figure 3 est une vue simplifiée, en coupe transversale partielle, de la roue de transfert qui fait suite à cette roue distributrice d'entrée ;

- Figure 4 est une vue agrandie du détail A de cette figure 3 ;

- Figure 5 est une vue simplifiée, et en perspective, de la partie de l'installation où est effectuée la mesure de la résistance d'isolement des condensateurs chips ;

- Figure 6 montre, en coupe schématique partielle selon un plan radial de la roue, le dispositif mécanique de sélection des composants, dans sa position où il s'agit d'un composant détecté comme une pièce mauvaise ;

- Figure 7 est une vue semblable à la figure 6, mais montrant l'action de sélection d'une pièce bonne ; et

- Figure 8 est une vue agrandie montrant la transition entre la roue de sélection associée au dispositif selon les figures 6 et 7 et la roue de récupération de toutes les pièces bonnes.

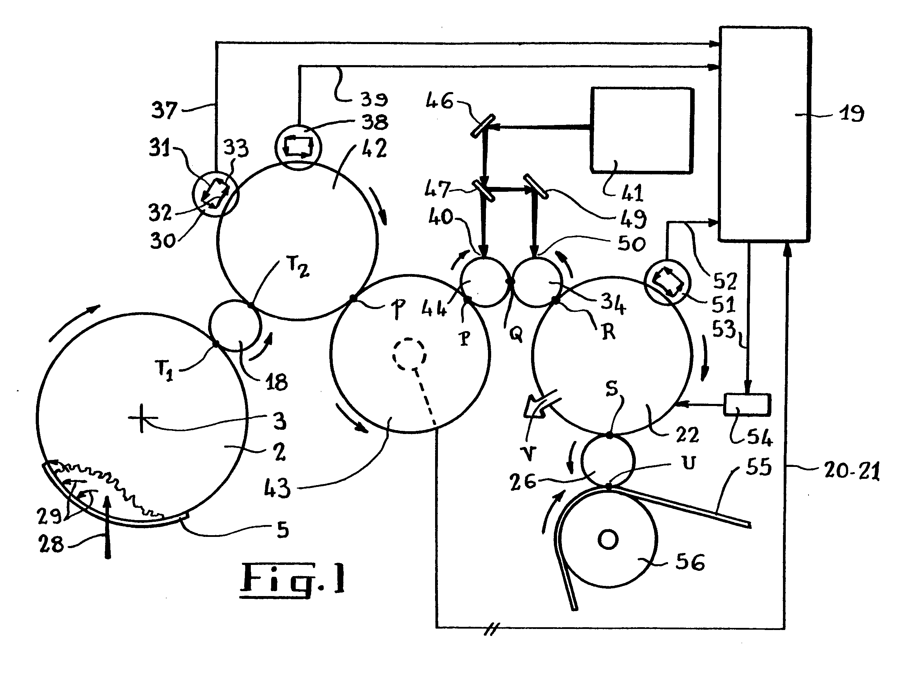

En se reportant tout d'abord à la figure 1, il s'agit d'une machine qui comporte une cascade de roues distributrices de composants chips, ces roues distributrices étant des roues à alvéoles extérieures régulièrement réparties et étant, de l'amont vers l'aval, référencées 2, 18, 42, 43, 44, 18, 22 et 26. Ces roues successives sont agencées pour que deux roues adjacentes (par exemple la roue 2 et la roue 18) soient tangentes l'une à l'autre afin de permettre le transfert un à un des composants chips d'une roue à la suivante au point de tangence de ces deux roues.

Les roues distributrices de composant chips sont, d'une façon générale, bien connues dans la technique, et elles comportent, sur leur pourtour extérieur, des alvéoles régulièrement réparties qui, classiquement, reçoivent chacune un composant chips. Un dispositif d'aspiration/soufflage est associé à ce jeu d'alvéoles, et a pour rôle de maintenir chaque composant chips dans son alvéole sur une portion déterminée de son trajet circonférentiel, et de l'en éjecter ensuite en un point précis de ce même trajet circonférentiel. Dans le cas présent certaines roues sont particulières en se sens qu'elles sont aptes à recevoir deux composants chips par alvéole, comme il sera explicité ci-après.

Les condensateurs chips sont tout d'abord, en sortie de leur chaîne de fabrication, testés et classés sur un équipement de mesure classique, non représenté. Ce sont les condensateurs chips d'une certaine catégorie (par exemple ceux dont la capacité est égale à la capacité nominale à 5 % près) qui sont introduits dans la machine de contrôle et mise sur bande de la figure 1

Ces condensateurs chips sont disposés en vrac, comme indiqué par la flèche 28 sur la figure 1, en un endroit "amont" de la première roue distributrice 2, cette roue étant bordée en cet endroit par une tôle fixe de retenue 5. Ces condensateurs chips se répartissent, comme schématisé par les flèches 29, dans les alvéoles extérieures de cette roue rotative 2 d'axe 3, dans lesquelles ils sont maintenus par aspiration.

Au point de tangence T avec la roue 18, ces composants sont transférés par soufflage sur cette deuxième roue distributrice 18. Cette roue 18 est une roue de transfert et, après avoir parcouru une demi-circonférence de cette dernière, les condensateurs sont transférés sur une autre roue 42 au point de tangence T2.

Lors de leur trajet sur cette roue à alvéoles 42, les condensateurs sont tous soumis successivement à deux tests de mesure :

. Une mesure de capacité et d'angle de perte (ou "tangente") qui est effectuée sur un premier poste de mesure 30 comportant des sondes de mesure qui effectuent chacune un trajet 31 en forme de boucle comportant un trajet "aller" 32 qui jouxte une faible portion de la circonférence périphérique de la roue 42, et un trajet de retour 33 effectué de manière plus rapide. Le long de son trajet parallèle à l'arc de cercle 32, chaque condensateur chips est mis en contact avec une des sondes de mesure de la boucle 31, cette sonde l'accompagnant le long de cet arc de cercle. Les mesures de capacité et d'angle de perte effectuées par cette sonde sont transmises à un organe central de commande et de calcul 19 au moyen d'une liaison électrique 37.

. Une mesure de tenue au claquage qui est effectuée sur un poste de mesure 38, semblable au poste 30 précité. Ce poste de mesure est lui-aussi relié à l'ordinateur central 19, par une autre liaison électrique 39.

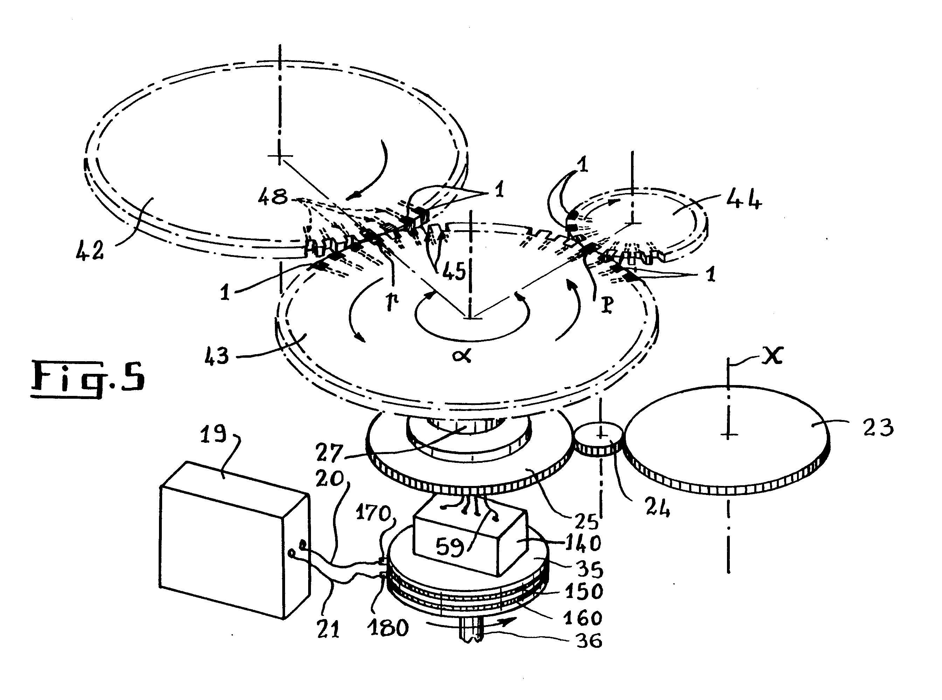

Au point de tangence p, les condensateurs sont transférés un à un, par soufflage-aspiration, sur la roue distributrice suivante 43. Ils se déplacent sur cette roue entre p et P et, au cours de cette portion de trajet circonférentiel, il est effectué pour chacun d'eux une mesure de résistance d'isolement, qui sera détaillée ultérieurement en référence à la figure 5, et dont le résultat est transmis à l'ordinateur central 19 par les deux fils 20, 21.

Au point suivant P, chaque condensateur est transféré sur une autre roue distributrice 44 qui lui fait parcourir une portion de circonférence entre P et Q. Au cours de ce trajet, sa face apparente reçoit, en 40, un marquage laser 41 qui est associé à des miroirs 46, 47 et 49.

Au point Q, les condensateurs sont transférés un à un sur une roue 34 de marquage de leur deuxième face, opposée à la face déjà marquée. Cette roue est particulière car, à l'instar de la roue 2, elle comporte des alvéoles doubles, c'est-à-dire aptes chacune à recevoir, dans le sens axial, deux composants chips mis bout-à-bout.

Chaque condensateur effectue sur cette roue 34, trois quarts de tour environ avant de recevoir en 50 le marquage au laser de leur deuxième face.

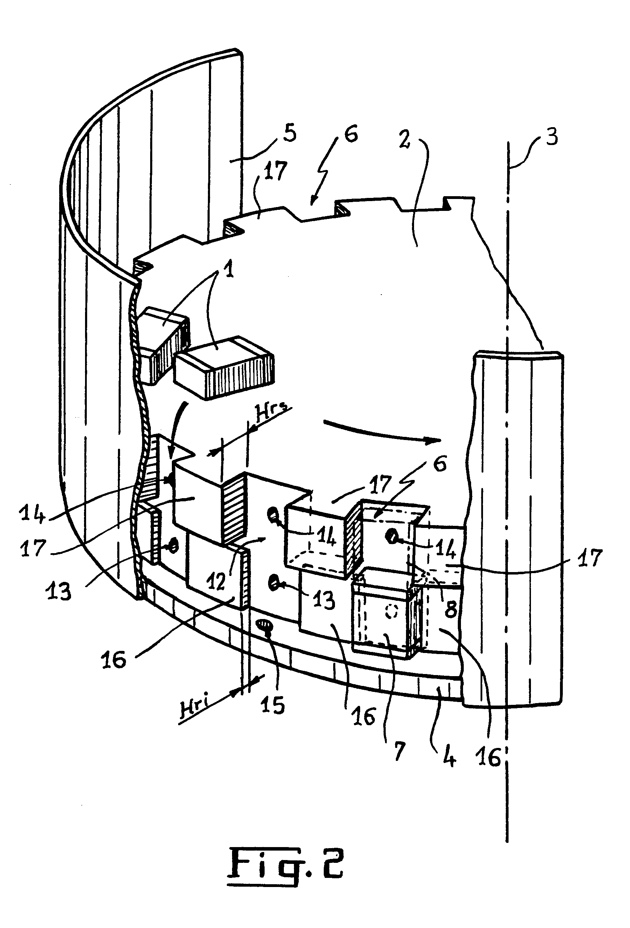

Afin d'éviter d'être écrasé entre un autre condensateur au point Q, provenant de la roue 44, ce même condensateur est, à l'aide d'un poussoir axial non représenté, déplacé axialement dans son alvéole, et termine enfin en R son parcours sur la roue 18 pour être transféré sur la roue distributrice suivante 22 qui est, elle-aussi, une roue à alvéoles doubles du même genre que les roues 34 et 2. Cette roue 22 ne comporte toutefois pas, entre chacune de ses alvéoles doubles, de dent "supérieure" 17 (figure 2).

Ce même condensateur parcourt une portion de la circonférence périphérique de cette roue 22. Il passe tout d'abord, au cours de ce trajet, le long d'un poste 51 de mesure redondante de capacité et d'angle de perte. Ce poste de mesure, qui est identique au poste de mesure précédent 30, est relié à l'ordinateur central 19 par une liaison électrique 52.

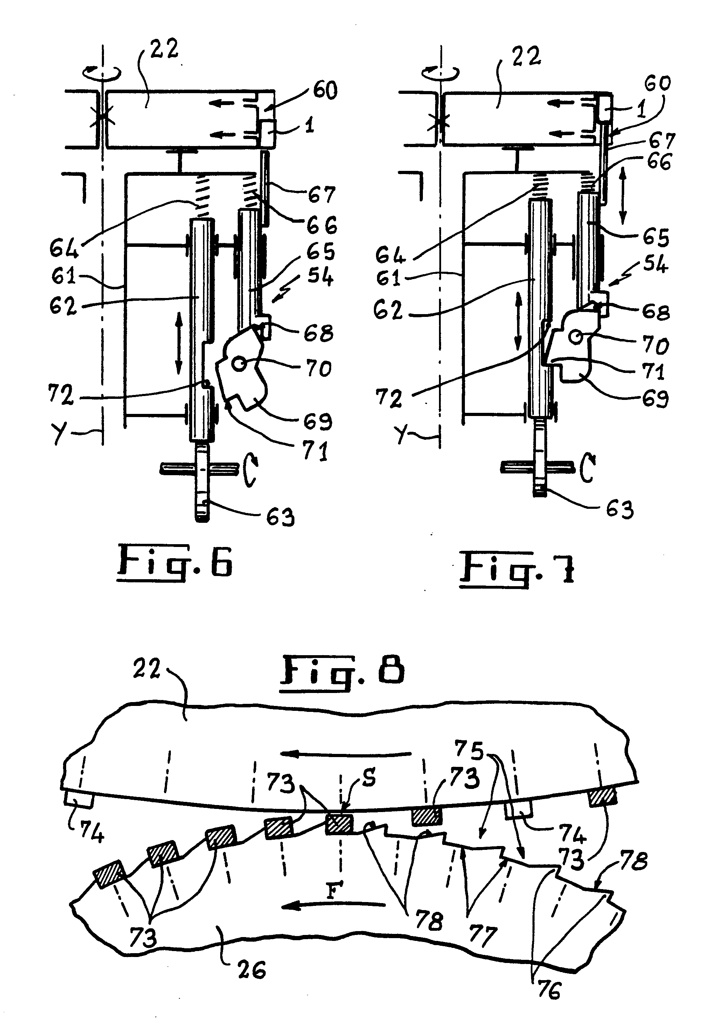

Les mesures fournies à l'ordinateur 19 par les fils 20, 21, 37, 39 et 52, sont exploitées par celui-ci pour décider de la qualité de chaque condensateur : "bon" ou "mauvais". A chaque pièce reconnue comme "bonne", un signal est appliqué par la connexion 53 à un organe mécanique 54 (décrit ci-après en référence aux figures 7 et 8), qui vient pousser le condensateur correspondant dans le fond de son alvéole.

Au point S de tangence avec la roue distributrice suivante 26, seuls les condensateurs qui se trouvent dans le fond d'une alvéole double de la roue 22 peuvent être transférés dans l'alvéole simple correspondante de cette roue 26. Si un tel transfert n'a pas lieu, ce que détecte une cellule photoélectrique, la roue 26 reste immobile, et n'avance d'un pas à nouveau que lorsqu'elle a reçu un condensateur "bon" en provenance de la roue 22 : la roue 26 ne contient donc que des pièces "bonnes", et toutes ses alvéoles, comprises entre le point de transfert S précité et un point de transfert suivant U situé plus en aval, sont chacune remplies d'un composant chips reconnu comme "bon".

Sur la roue 22, les condensateurs "mauvais", qui n'ont pas été poussés dans le fond de leur alvéole double par le dispositif 54, sont éjectés par soufflage au point V, et ils tombent dans un bac de récupération et destruction.

On remarque déjà, à ce stade de la description, qu'en cas de défaillance du dispositif de sélection 54, aucune pièce ne sera poussée dans le fond de son alvéole, de sorte que la roue 26 ne pourra jamais recevoir de pièce "mauvaise", ce qui est essentiel car il est beaucoup plus grave de mettre sur bande de livraison de mauvaises pièces que d'en détruire des bonnes en V.

Au point de tangence U, les pièces bonnes sont transférées par soufflage sur une bande distributrice de composants chips 55, d'un modèle en soi connu, qui passe autour d'un cylindre rotatif 56.

La figure 2 montre plus en détails la structure tout à fait particulière de la roue distributrice d'entrée 2. Il s'agit en fait d'un dispositif de réception et de distribution de composants chips 1 qui comporte d'une part une partie tournante constituée par la roue 2 précitée, d'axe 3 incliné par rapport à la verticale, et d'autre part une partie fixe constituée par un plateau circulaire 4 sur lequel la roue 2 tourne presque sans frottement, ainsi que par la tôle 5 précitée, qui est cintrée en arc de cercle et soudée à sa base sur une fraction du pourtour extérieur de ce plateau circulaire 4. Le diamètre du plateau 4 est légèrement supérieur à celui de la roue 2, de sorte que cette dernière tourne sans frotter contre la tôle cintrée 5.

La roue 2 est pourvue, sur toute sa périphérie externe, d'alvéoles 6 identiques et régulièrement réparties, aptes chacune à recevoir deux composants chips 7, 8, alignés dans le sens axial, c'est-à-dire mis bout à bout en position "debout", comme schématisé figure 2.

Radialement parlant, la surface de fond 12 de chaque alvéole 6 est uniforme, et elle est pourvue de moyens de maintien ou d'éjection des deux composants chips 7, 8, qui sont constitués par deux orifices 13, 14 d'aspiration ou de soufflage radial. Il est en outre avantageusement prévu dans le plateau 4 au moins un orifice axial d'aspiration 15 regardant vers la partie interne des alvéoles 6.

Enfin, les alvéoles successives 6 sont à chaque fois séparées par deux dents 16, 17, superposées axialement et formant bloc avec la roue 2. Afin de faciliter l'échange des composants chips inférieurs 7 avec la roue preneuse adjacente, la hauteur radiale Hri de la dent inférieure 16 est inférieure à celle Hrs de la dent supérieure 17.

En fonctionnement, la roue 2 tourne dans le sens anti-horaire, et les condensateurs chips 1 sont jetés en vrac sur celle-ci, dans la zone bordée par la tôle 5. L'axe 3 est incliné de façon que cette zone soit la zone la plus basse de la roue, de sorte que tous les condensateurs 1 se rassemblent naturellement dans cette même zone.

La force centrifuge et l'aspiration par l'orifice 15 aidant, les condensateurs 1 tombent dans les alvéoles 6, comme représenté figure 2. Il en tombe en général deux par alvéole, quelque fois un seul, mais en tous cas jamais zéro, de sorte que l'on est ainsi assuré que chaque alvéole comporte un composant chips 7 dans sa partie inférieure, ce qui est le but rechérché.

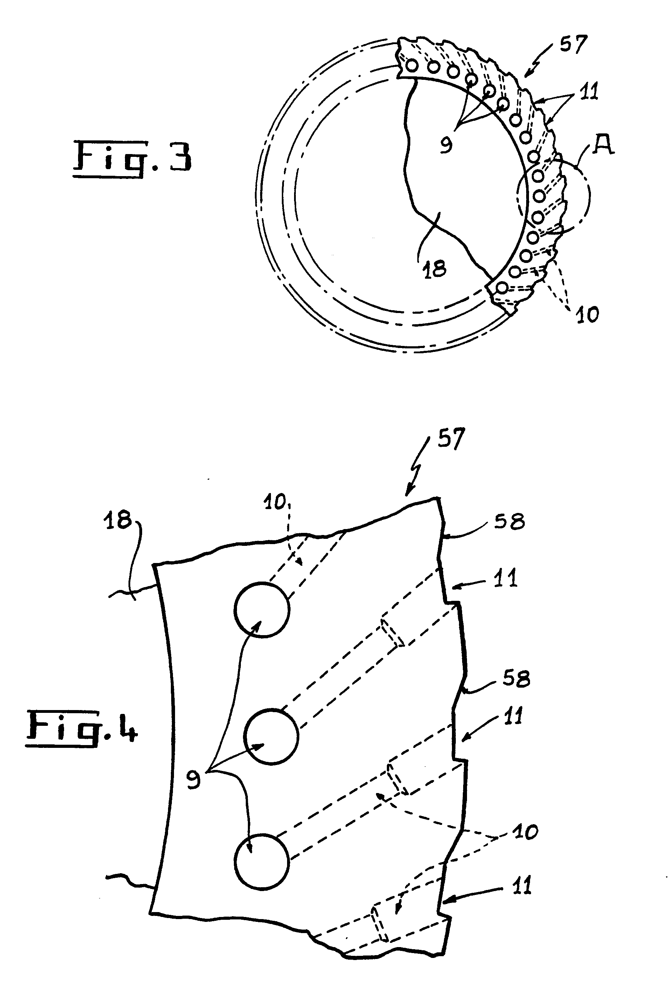

La roue intermédiaire de transfert 18 est représentée plus en détails aux figures 3 et 4. Il s'agit d'une roue distributrice classique, pourvue de canaux 9, 10 d'aspiration/soufflage et d'alvéoles 11. Cette roue présente la particularité d'avoir un bandage extérieur souple 57 en polyuréthane et, pour les alvéoles 11 qui sont formées dans ce bandage, un profil qui présente, dans le sens circonférentiel, un bord incliné 58, afin d'éviter de casser les composants mal orientés et, d'une manière générale, afin de faciliter l'achange entre les roues 2 et 18.

La roue 18 est apte à recevoir un seul composant chips par alvéole 11, et elle est placée de manière à ne pouvoir recevoir, venant de la roue 2, que le composant chips 7 qui est placé dans la moitié inférieure précitée d'une alvéole 6 de cette roue 2, l'autre composant 8 étant recyclé.

Le dispositif de mesure de résistance d'isolement, associé à la roue 43, est schématisé sur la figure 5. Cette mesure s'effectue sur l'angle $\alpha$ qui définit, entre les points p et P, le parcours des composants 1 sur une portion de la circonférence externe de la roue 43. Ces composants chips 1 sont alimentés dans les alvéoles successives de la roue 42, dans lesquelles ils sont retenus par l'aspiration exercée par les canaux d'aspiration/soufflage 48. Ils sont transférés au point p sur la roue 43, puis, après avoir décrit le trajet d'angle $\alpha$, ils sont transférés au point P sur la roue suivante 44. Les trois roues 42 à 44 sont des roues à alvéoles simples, c'est-à-dire aptes à contenir chacune un seul composant chips, à l'inverse des roues 2, 34 et 22 (figure 1) qui sont des roues à alvéoles doubles.

La roue 43 est solidaire d'un arbre creux 27, qui est entrainé en rotation par l'intermédiaire d'une liaison mécanique 23 à 25. L'axe X de la roue 23 est solidaire de l'arbre d'entrainement d'un premier moteur électrique non représenté.

Des sondes de mesure non représentées, une paire par alvéole, sont appliquées entre les deux terminaisons soudables de chaque condensateur 1 tout le long de son trajet sur la roue 43. Les signaux électriques relevés par ces sondes sont transmis, par le réseau de fils 59 qui passe à l'intérieur de l'arbre creux 27, à un appareil de mesure 140 qui est fixé sur un tambour tournant 35. Ce tambour 35 est entrainé en rotation, par un deuxième moteur électrique lié à son arbre 36, à la même vitesse et dans le même sens que la roue 43. Par rapport à cette dernière, l'appareil de mesure embarqué 140 est donc immobile.

Les signaux amplifiés qui sortent de l'appareil 140 apparaissent sur les deux bagues collectrices 150, 160 du tambour 35, et ils sont captés par deux balais fixes 170, 180 et transmis à l'ordinateur central 19 par les deux fils précités 20 et 21.

Les figures 6 et 7 montrent le dispositif 54 de sélection des pièces "bonnes".

Comme mentionné précédemment, la roue 22 est, à l'instar des roues 2 et 34, une roue à alvéoles 60 doubles, c'est-à-dire aptes chacune à recevoir deux composants chips 1 mis bout-à-bout dans le sens axial. Cette roue est supportée par un palier fixe 61, qui sert également de glissière pour une tige mobile 62 animée d'un mouvement de va-et-vient parallèle à l'axe Y de la roue 22 sous commande d'une came rotative 63 qui agit contre la force de répulsion d'un ressort 64.

Le palier 61 sert aussi de glissière pour une autre tige 65, parallèle à la tige 62 et repoussé dans le même sens que cette dernière par un autre ressort 66. L'extrémité libre de cette tige 65 porte un poussoir 67 qui, lorsqu'il est en position haute selon la figure 7, vient s'engager dans l'alvéole 60 qui se trouve au droit de ce poussoir, et vient par suite pousser le composant chips 1 dans le fond de cette alvéole. L'autre extrémité 68 de la tige 65 prend appui sur une pièce basculante 69 dont l'axe de rotation 70 est commandé positivement, dans un sens ou dans l'autre pour provoquer le basculement, par un actionneur non représenté qui reçoit son impulsion de commande de l'ordinateur 19 par le fil 53 (figure 1).

Lorsque la pièce 69 est basculée (figure 7), une partie proéminente 71 de celle-ci, formant épaulement, vient s'engager dans un évidement correspondant 72 prévu à cet effet sur le flanc de la tige 62, ce qui solidarise les deux tiges 62 et 65. Le poussoir 67 est alors embrayé et par suite animé du même mouvement que la tige 62. Après chaque impulsion de commande de basculement, la bascule 69 revient, quoi qu'il en soit, à son état initial de la figure 6.

Lorsqu'au contraire, la pièce 69 n'est pas basculée (figure 6), la tige 65 n'est pas embrayée sur la tige 62, de sorte que le poussoir 67 reste immobile et en position basse.

L'ordinateur 19 commande le basculement de la pièce basculante 69 lorsque le composant chips 1, qui se trouve dans l'alvéole 60 au droit du poussoir 67, a été reconnu comme "bon" en raison des mesures effectuées précédemment.

Rappelons que (figure 5) la roue 44 est une roue à alvéoles simples. Les alvéoles de cette roue 44 sont placées en face de la moitié "supérieure" des alvéoles doubles de la roue 34. On a vu précédemment qu'après un marquage par la tête laser 50, les condensateurs chips sont transférés dans le fond (moitié "inférieure") de l'alvéole double correspondante de la roue 34. Les roues 34 et 22, qui sont toutes deux des roues à alvéoles doubles à l'instar de la roue 2, sont disposées de façon que les condensateurs chips 1 soient transférés, au point R (figure 1), de la partie "inférieure" de l'alvéole double de la roue 34 vers la partie "inférieure" de l'alvéole double correspondante 60 (figure 6) de la roue 22. Un composant chips reconnu comme bon est ensuite transféré (figure 7) vers le sommet, ou partie "supérieure", de cette alvéole 60. La roue suivante 26 est une roue dont les alvéoles "simples" sont placées au droit de cette partie "supérieure" des alvéoles correspondantes 60 de la roue 22 : il s'ensuit que seules des pièces "bonnes" peuvent être transférées sur cette roue preneuse 26.

En cas de défection mécanique du sélecteur 54, la bascule 69 ne sera pas actionnée, et restera ou reviendra alors dans sa position "débrayée" de la figure 6. Dans un tel cas, aucun condensateur ne sera pris par la roue 26, et toutes les pièces, bonnes ou mauvaises, seront éjectées et détruites au point Y, ce qui est un moindre mal car il est bien plus gênant de placer sur bande des pièces mauvaises que de détruire quelques pièces bonnes avant que l'on ait pu constater la défaillance. La séparation "pièces-bonnes, pièces-mauvaises" est donc telle que si l'organe de transfert 54 est défaillant, ce sont les pièces bonnes qui passent dans les mauvaises, et non pas le contraire.

La figure 8 montre le détail du transfert, au point S, des pièces bonnes 73 de la roue 22 vers la roue 26. Ce transfert est réalisé de façon souple et progressive, avec changement de pas, de la roue 22 vers la roue preneuse 26 grâce au profil transversal particulier des alvéoles 75 de cette roue 26. Ce profil est tel qu'en coupe transversale, selon la figure 8, il présente dans le sens de rotation indiqué par la flèche F, une forme de dent de scie 76 suivie d'un plat 77 contigü à la partie en pente douce 78 de cette dent de scie 76. Les pièces mauvaises 74 restent sur la roue 22 au delà du point S, pour en être éjectées un peu plus loin, puis détruites.

Comme il va de soi, l'invention n'est pas limitée à l'exemple de réalisation qui vient d'être décrit. Le marquage par le laser 41 pourrait n'être effectué que sur une seule face. La machine pourrait être conçue pour traiter d'autres composants chips que des condensateurs, par exemple pour des résistances ou des varistances, etc...

## Revendications

1 - Installation de contrôle automatique de composants électroniques du type chips (1), caractérisée en ce qu'elle comporte une cascade de roues rotatives distributrices de composants chips (2, 18, 42, 43, 44, 34, 22, 26), ces roues successives étant agencées pour que deux roues adjacentes (2 et 18, 18 et 42, 42 et 43, 43 et 44, 44 et 34, 34 et 22, 22 et 26) soient tangentes l'une à l'autre afin de permettre le transfert un à un de ces composants chips d'une roue à la suivante au point de tangence (T1, T2, p, P,Q, R, S) de ces deux roues, au moins certaines (42, 43, 22) de ces roues étant associées à des sondes de mesure qui sont aptes à effectuer une prise de mesure de contrôle sur chacun des composants chips transportés par la roue correspondante sans arrêter le mouvement de rotation de cette roue, au moins la première (2) de ces roues étant une roue de collection et de distribution un à un de composants chips d'entrée (1), et au moins la dernière (26) de ces roues étant une roue de mise sur bande (55) un à un des composants chips (73) ayant subi des mesures sur des roues intermédiaires (42, 43, 22) et ayant par suite été sélectionnés comme bons par un organe central de commande et de calcul (19), des moyens (54) commandés par cet organe central (19) étant en outre prévus pour interdire l'accès à cette dernière roue (26) des composants non sélectionnés (74), de sorte que seuls des composants sélectionnés comme bons (73) sont mis sur bande (55).

2 - Installation de contrôle automatique selon la revendication 1, caractérisée en ce que ladite roue (2) de collection et de distribution de composants chips (1) est une roue dont les alvéoles extérieures (6) sont chacune aptes à recevoir deux composants chips (7, 8) mis bout-à-bout dans le sens axial.

3 - Installation de contrôle automatique selon la revendication 1 ou la revendication 2, caractérisée en ce qu'une roue (22), munie d'alvéoles extérieures aptes chacune à recevoir deux composants chips mis bout-à-bout dans le sens axial, est prévue en sortie de la dernière mesure de contrôle (51) dans le but de classer, en les poussant ou non dans le fond de leur alvéole (60) au moyen d'un organe (67) commandé par l'organe central (19), les divers composants (1) en composants sélectionnés comme bons (73) au mauvais (74)

4 - Installation de contrôle automatique selon l'une des revendications 1 à 3, caractérisée en ce qu'au moins une des roues intermédiaires de mesure (43) est associée à un dispositif de mesure dont au moins une partie (140) est embarquée, c'est-à-dire est synchronisée en rotation avec cette roue (43).

5 - Installation de contrôle automatique selon l'une des revendications 1 à 4, caractérisée en ce qu'au moins une des roues intermédiaires (44, 34) est associée à un dispositif (41) de marquage des composants chips.

6 - Installation de contrôle automatique selon la revendication 5, caractérisée en ce que, dans le but d'effectuer un marquage sur deux faces opposées du composant chips, les deux marquages (40, 50) s'effectuent respectivement sur deux roues successives (44, 34), et en ce qu'au moins la seconde (34) de cette roue est une roue dont les alvéoles extérieures sont chacune aptes à recevoir deux composants chips mis bout-à-bout dans le sens axial, un dispositif étant prévu pour pousser chaque composant chips, après marquage de sa deuxième face, dans le fond de son alvéole double.

7 - Installation de contrôle automatique selon l'une des revendications 1 à 6, caractérisée en ce qu'au moins une des roues intermédiaires (18) présente un bandage extérieur souple (57) et, pour les alvéoles (11) qui sont formées dans ce bandage (57), un profil qui possède dans le sens circonférentiel, un bord incliné (58) apte à éviter de casser les composants (1) mal orientés ainsi qu'à faciliter l'échange de ces composants.

8 - Installation de contrôle automatique selon l'une des revendications 1 à 7, caractérisée en ce qu'elle contient au moins une roue preneuse (26) dont les alvéoles (75) ont un profil transversal en forme de dent de scie (76) suivie d'un plat (77) contigü à la partie en pente douce (78) de cette dent de scie (78).

9 - Installation de contrôle automatique selon l'une des revendications 1 à 8, caractérisée en ce qu'elle comporte un dispositif (Y) d'éjection et de destruction des composants chips (74) qui n'ont pas été sélectionnés comme bons.

10 - Installation de contrôle automatique selon la revendication 3, caractérisée en ce que les moyens pour pousser les composants sélectionnés comme bons dans le fond de leur alvéole comportent un dispositif d'embrayage à bascule (69) qui reste nécessairement débrayé en cas de défectuosité mécanique, de sorte qu'il n'est pas possible de classer des pièces mauvaises parmi les bonnes.

Fig.1

Fig. 2

Fig.3

Fig.4

Fig.5

**Fig. 6**

**Fig. 7**

**Fig. 8**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | COMPUTERS IN INDUSTRY, vol. 10, no. 2, juillet 1988, pages 147-153, Elsevier Science Publishers B.V. (North-Holland), Amsterdam, NL; R. KRISHNAMOORTHY et al.: "Mu-processor based capacitor testing and sorting" * Page 148, figure 1 * --- | 1 | G 01 R 31/02 |
| A | IBM TECHNICAL DISCLOSURE BULLETIN, vol. 14, no. 1, juin 1971, page 162; A. KOSTENKO et al.: "Gravity-feed loader for turntable" ----- | | |

**DOMAINES TECHNIQUES RECHERCHES (Int. Cl.5)**

G 01 R 31/00
H 05 K 13/00

Le présent rapport a été établi pour toutes les revendications

| Lieu de la recherche | Date d'achèvement de la recherche | Examinateur |
|---|---|---|
| LA HAYE | 26-03-1990 | TRELEVEN C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P0402)